(19) 

**Europäisches Patentamt**

**European Patent Office**

**Office européen des brevets**

(11) **EP 4 546 998 A1**

(12) **EUROPEAN PATENT APPLICATION**
published in accordance with Art. 153(4) EPC

(43) Date of publication:
30.04.2025 Bulletin 2025/18

(21) Application number: 23826366.9

(22) Date of filing: 19.06.2023

(51) International Patent Classification (IPC):
*H10N 30/88* [(2023.01)]     *H10N 30/20* [(2023.01)]

(86) International application number:
PCT/CN2023/101163

(87) International publication number:
WO 2023/246718 (28.12.2023 Gazette 2023/52)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 22.06.2022 CN 202210708090

(71) Applicant: Yinguan Semiconductor Technology
Co., Ltd.
Shanghai 201206 (CN)

(72) Inventors:
• ZHU, Kai
Shanghai 201206 (CN)
• WANG, Zhenhua
Shanghai 201206 (CN)
• GONG, Wei
Shanghai 201206 (CN)

(74) Representative: Zacco GmbH
Bayerstrasse 83
80335 München (DE)

(54) **PIEZOELECTRIC ACTUATOR AND MOVING DEVICE**

(57)     The present invention provides a piezoelectric actuator and a moving device. The piezoelectric actuator includes: a housing assembly internally provided with an accommodating chamber having an open at an end; a piezoelectric assembly arranged in the accommodating chamber and including a plurality of piezoelectric elements, where the piezoelectric elements are stacked sequentially in an axial direction; and at least one protective assembly arranged in the accommodating chamber and at least a part of the protective assembly is arranged between an inner wall of the housing assembly and an outer wall of the piezoelectric assembly. When two or more protective assemblies are arranged, a plurality of protective assemblies are spaced one above another Through the piezoelectric actuator provided in the present invention, the problem that a ceramic stack of a prior piezoelectric actuator is prone to fracture is solved.

Fig. 4

EP 4 546 998 A1

## Description

The present application claims the priority of Chinese Patent Application No. 202210708090.4, filed with the Chinese Patent Office on June 22, 2022 and entitled "Piezoelectric actuator and moving device".

## Technical Field

The present invention relates to the technical field of micro-drive, in particular to a piezoelectric actuator and a moving device.

## Background

A piezoelectric actuator works on a principle that when a certain voltage is applied to a piezoelectric ceramic stack, the piezoelectric ceramic stack deforms in an axial direction due to an inverse piezoelectric effect of piezoelectric material, so as to output displacement.

However, due to limitation of assembly precision, the piezoelectric actuator is inevitable subjected to a tangential force $F_T$ during use, and a long stack with a low stiffness is more prone to generate a large strain in a radial direction to cause fracture, as shown in Fig. 1. Moreover, stiffness reduction leads to lowered stability of a stack compression strut. As shown in Fig. 2, the ceramic stack fractures directly because brittleness and insufficient bonding strength of the piezoelectric ceramic material. Further, stiffness reduction also reduces a resonant frequency of the ceramic stack, making the ceramic stack more susceptible to external excitation (e.g., vibration and impact during transportation) and causing fracture, as shown in Fig. 3.

For a longer-stroke working condition, a longer piezoelectric stack is required, and an elongation of the piezoelectric ceramic stack reduces the overall stiffness of the ceramic stack, causing the ceramic stack to be more prone to fracture.

## Summary

In view of the above shortcomings in the prior art, an objective of the present invention is to provide a piezoelectric actuator and a moving device for solving the problem that ceramic stacks in a prior piezoelectric actuator are prone to fracture, so as to achieve a long-stroke working condition of the piezoelectric actuator.

In order to achieve the above objective and other related objectives, the present invention provides a piezoelectric actuator. The piezoelectric actuator includes:

   a housing assembly internally provided with an accommodating chamber having an opening at an end;

   a piezoelectric assembly arranged in the accommodating chamber, and including a plurality of piezoelectric elements, where the piezoelectric elements are stacked sequentially in an axial direction; and

   at least one protective assembly, arranged in the accommodating chamber and at least a part of the protective assembly is arranged between an inner wall of the housing assembly and an outer wall of the piezoelectric assembly. When two or more protective assemblies are arranged, a plurality of protective assemblies are spaced one above another.

In some embodiments, the protective assembly includes a limiting member, at most one side of the limiting member is fixed relative to the inner wall of the housing assembly or the outer wall of the piezoelectric assembly, and a non-fixed side of the limiting member is attached to the inner wall of the housing assembly and/or the outer wall of the piezoelectric assembly; the limiting member has at least one lubricated surface, and the lubricated surface is at least arranged on the non-fixed side of the limiting member.

In some embodiments, an outer side of the limiting member is fixedly connected to the inner wall of the housing assembly, an inner side of the limiting member is closely attached to the outer wall of the piezoelectric assembly, and the lubricated surface is at least arranged on the inner side of the limiting member.

In some embodiments, an outer side of the limiting member is closely attached to the inner wall of the housing assembly, an inner side of the limiting member is fixedly connected to the outer wall of the piezoelectric assembly, and the lubricated surface is at least arranged on the outer side of the limiting member.

In some embodiments, an outer side of the limiting member is closely attached to the inner wall of the housing assembly, an inner side of the limiting member is closely attached to the outer wall of the piezoelectric assembly, and the lubricated surfaces are at least provided on the outer side and the inner side of the limiting member.

In some embodiments, when the limiting member is arranged at a joint of two adjacent piezoelectric elements, the protective assembly further includes an adapter fixedly connected between the two adjacent piezoelectric elements, an inner side of the limiting member is fixedly connected to the adapter, an outer side of the limiting member is closely attached to the inner wall of the housing assembly, and in this case, the lubricated surface is at least arranged on the outer side of the limiting member.

In some embodiments, a sliding groove is formed on the inner wall of the housing assembly opposite the limiting member, and the limiting member is arranged in the sliding groove.

In some embodiments, an equivalent friction coefficient of the limiting member satisfies a formula

$$\begin{cases} \text{k}\left(D - \delta\right)\mu \leq \sigma A \\ \text{k} = \dfrac{EA_i}{D} \\ \sigma = Max\left(\sigma_{ad}, \sigma_{ce}\right) \end{cases}$$

, where k is a stiffness of the limiting member, D is a thickness of the limiting member, $\delta$ is a distance between the inner wall of the housing assembly and the outer wall of the piezoelectric assembly, $\mu$ is the equivalent friction coefficient of the limiting member, E is a Young's modulus of the limiting member, A is a cross sectional area of the piezoelectric assembly, $A_i$ is an effective pressing area of the piezoelectric assembly to the limiting member, $\sigma$ is a tensile strength of the piezoelectric assembly, $\sigma_{ad}$ is a tensile adhesion strength of the piezoelectric assembly, and $\sigma_{ce}$ is a tensile strength of a single piece of piezoelectric ceramic of the piezoelectric assembly.

In some embodiments, the piezoelectric actuator further includes:

a cover plate arranged at the opening, where the cover plate is connected with the housing assembly, and the cover plate has a through opening with a stepped cross section; and

an output assembly including a base and a penetration member, where the base is connected with the piezoelectric assembly, the penetration member is arranged on the base and extends upwards to pass through the through opening, the output assembly has a stepped cross section, and the output assembly and the cover plate define a movement space at a wide area of the through opening.

In some embodiments, the piezoelectric actuator further includes an elastic assembly arranged in the movement space and arranged around an outer side of the penetration member.

In some embodiments, the elastic assembly includes a disc spring and/or a spring.

In some embodiments, a first gap and a second gap are formed between an outer wall of the penetration member and an inner wall of the through opening, and the second gap is greater than the first gap; and the first gap satisfies a formula $\delta 1 < \omega_{max}$, where $\delta 1$ is the gap, and $\omega_{max}$ is a maximum deflection of flexible deformation of the piezoelectric assembly.

In some embodiments, the piezoelectric element includes a single piece of piezoelectric ceramic or a piezoelectric ceramic stack, and the piezoelectric ceramic stack includes at least two single piece of piezoelectric ceramics stacked one above the other.

The present invention further provides a moving device. The moving device includes the piezoelectric actuator according to any one of above items.

As described above, in the piezoelectric actuator and the moving device of the present invention, one or more limit positions are added to the piezoelectric assembly in the radial direction by adding the protective assembly, so as to reduce a flexible deformation of the piezoelectric assembly and prevent the piezoelectric assembly from fracturing. Further, the protective assembly is also able to serve as a guide and provide a certain axial movement space, such that extension and contraction of the piezoelectric assembly is smooth and unobstructed, and phenomena of movement halt and stack fracture are prevented. Furthermore, the protective assembly is beneficial to increase a length of the piezoelectric assembly, so as to increase a stroke of the piezoelectric actuator. The piezoelectric actuator disclosed in the present invention not only has high stability and high reliability, but also has a longer stroke.

**Brief Description of the Drawings**

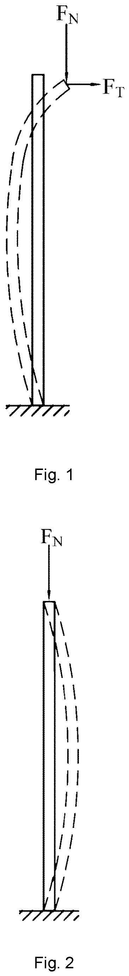

Fig.1 is a schematic diagram of eccentric fracture of a long stack of a piezoelectric actuator under stress in the prior art;

Fig.2 is a schematic diagram of buckling fracture of a long stack of a piezoelectric actuator under positive pressure in the prior art;

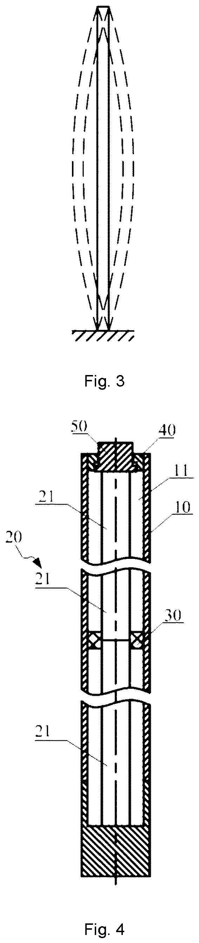

Fig.3 is a schematic diagram of fracture of a long stack of a piezoelectric actuator under external excitation in the prior art;

Fig. 4 is a schematic structural diagram of a piezoelectric actuator according to the present invention;

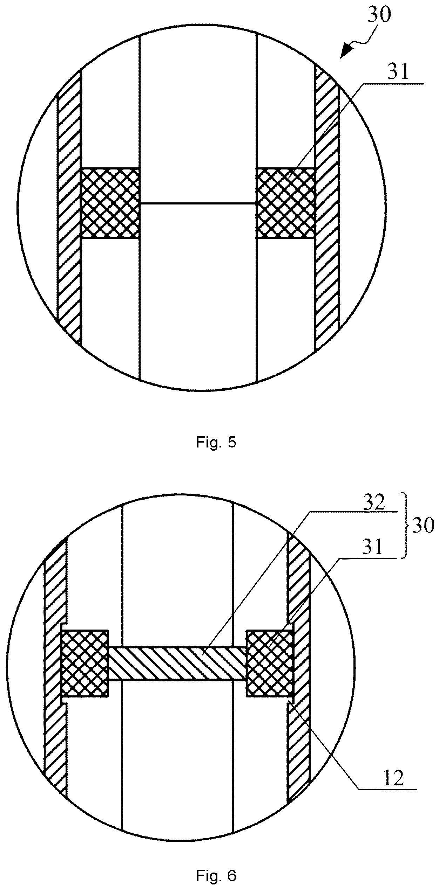

Fig. 5 is a schematic structural diagram of a protective assembly according to the present invention;

Fig. 6 is another schematic structural diagram of a protective assembly according to the present invention;

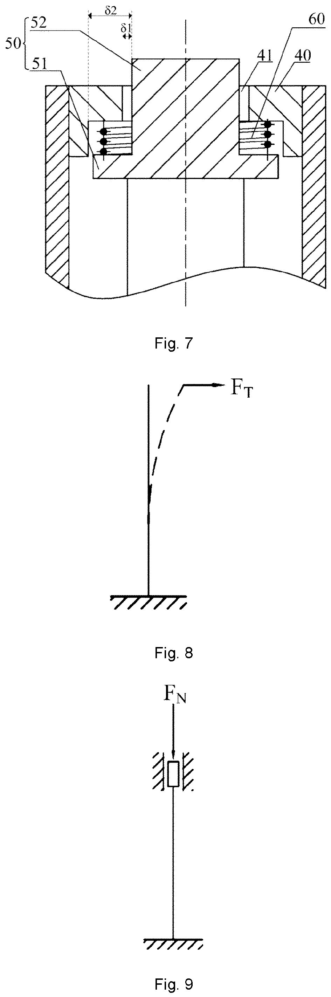

Fig. 7 is a schematic structural diagram of a cover plate, an output assembly and an elastic assembly according to the present invention;

Fig. 8 is a schematic diagram of a piezoelectric assembly that is equivalent to a cantilever beam structure with one end fixed according to the present invention;

Fig.9 is a schematic diagram of a piezoelectric assembly that is equivalent to an slender strut structure with two fixed ends according to the present invention; and

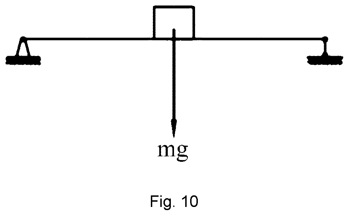

Fig. 10 is a schematic diagram of a piezoelectric assembly that is equivalent to a vibration system model of a cylindrical strutbeam according to the present invention.

Reference numerals:

10    housing assembly

11    accommodating chamber

12    sliding groove

20    piezoelectric assembly

21    piezoelectric element

30    protective assembly

31    limiting member

32    adapter

40    cover plate

41    through opening

50    output assembly

51    base

52    penetration member

60    elastic assembly

## Detailed Description of the Embodiments

The embodiments of the present invention are described below through specific instances, and those skilled in the art can easily understand other advantages and effects of the present invention from the contents disclosed in the specification. The present invention may also be implemented or applied in other different specific embodiments, and various modifications or changes may be made to various details in the specification based on different viewpoints and inventions without departing from the spirit of the present invention.

With reference to Figs. 4-10, it should be noted that the drawings provided in an example are only schematic illustrations of the basic concept of the present invention. Although the drawings only show the components related to the present invention rather than drawing according to the number, shape and size of the components in actual implementation, the shape, quantity and proportion of each component in actual implementation may be arbitrarily changed, and the component layout may be more complex.

As shown in Figs. 4-7, the example provides a piezoelectric actuator. The piezoelectric actuator includes a housing assembly 10, a piezoelectric assembly 20, and at least one protective assembly 30. The piezoelectric actuator further includes a cover plate 40 and an output assembly 50. Furthermore, the piezoelectric actuator includes an elastic assembly 60.

The housing assembly 10 has an accommodating chamber 11 having an opening at an end. The accommodating chamber 11 allows the piezoelectric assembly 20 to be mounted and fixed. The cover plate 40 is mounted and fixed to the opening of the accommodating chamber 11. The opening of the accommodating chamber 11 is also an external mounting positioning interface and a displacement output interface of the piezoelectric actuator. In practical application, a metal workpiece or a ceramic workpiece typically serves as the housing assembly 10 to protect the piezoelectric assembly 20 inside.

The piezoelectric assembly 20 is arranged in the accommodating chamber 11 and includes a plurality of piezoelectric elements 21. The piezoelectric elements 21 are stacked sequentially in an axial direction.

In some embodiments, the piezoelectric assembly 20 is a displacement generating structure. One end of the piezoelectric assembly 20 is fixed to a bottom end of the accommodating chamber 11 away from the opening, and the other end of the piezoelectric assembly 20 is fixedly connected with the output assembly 50. When a certain voltage is applied to the piezoelectric assembly 20, due to an inverse piezoelectric effect of piezoelectric material, the piezoelectric assembly 20 generates a certain deformation in an axial direction, and the deformation is transmitted to the output assembly 50 to output displacement.

More specifically, the piezoelectric element 21 includes a single piece of piezoelectric ceramic or a piezoelectric ceramic stack. The piezoelectric ceramic stack includes at least two single piece of piezoelectric ceramics stacked one above the other. In other words, the piezoelectric assembly 20 is composed of at least two single piece of piezoelectric ceramics, and the single piece of piezoelectric ceramics are stacked sequentially in the axial direction. By such stacking arrangement, a length of the piezoelectric assembly 20 as a whole in the axial direction may be increased to increase displacement output of the piezoelectric actuator.

The protective assembly 30 is arranged in the accommodating chamber 11. At least a part of the protective assembly 30 is arranged between an inner wall of the housing assembly 10 and an outer wall of the piezoelectric assembly 20. When two or more protective assemblies 30 are arranged, a plurality of protective assemblies 30 are spaced one above another.

In some embodiments, the protective assembly 30 includes a limiting member 31. At most one side of the limiting member 31 is fixed relative to the inner wall of the housing assembly 10 or the outer wall of the piezoelectric assembly 20, and a non-fixed side of the limiting member 31 is attached to the inner wall of the housing assembly 10 and/or the outer wall of the piezoelectric assembly 20. The limiting member 31 has at least one lubricated surface. The lubricated surface is at least arranged on the non-fixed side of the limiting member 31, that is to say, at least one non-fixed side of the limiting member 31 is provided with the lubricated surface.

More specifically, in order to guarantee stable work of the piezoelectric actuator, an equivalent friction coefficient of the limiting member 31 satisfies a formula

$$\begin{cases} k(D - \delta)\mu \leq \sigma A \\ k = \dfrac{EA_i}{D} \\ \sigma = Max(\sigma_{ad}, \sigma_{ce}) \end{cases}$$

, where k is a stiffness of the limiting member 31, D is a thickness of the limiting member 31, $\delta$ is a distance between the inner wall of the housing assembly 10 and the outer wall of the piezoelectric assembly 20, $\mu$ is the equivalent friction coefficient of the limiting member 31, E is a Young's modulus of the limiting member 31, A is a cross sectional area of the piezoelectric assembly 20, $A_i$ is an effective pressing area of the piezoelectric assembly 20 to the limiting member 31, $\sigma$ is a tensile strength of the piezoelectric assembly 20, $\sigma_{ad}$ is a tensile adhesion strength of the piezoelectric assembly 20, and $\sigma_{ce}$ is a tensile strength of a single piece of piezoelectric ceramic of the piezoelectric assembly 20.

It should be noted that when the limiting member 31 is fixed relative to the inner wall of the housing assembly 10, that is, when an outer side of the limiting member 31 is the fixed side and an inner side is the non-fixed side, the equivalent friction coefficient of the limiting member 31 is a friction coefficient between the limiting member 31 and the outer wall of the piezoelectric assembly 20. When the limiting member 31 is fixed relative to the outer wall of the piezoelectric assembly 20, that is, when the outer side of the limiting member 31 is the non-fixed side and the inner side is the fixed side, the equivalent friction coefficient of the limiting member 31 is a friction coefficient between the limiting member 31 and the inner wall of the housing assembly 10. When the limiting member 31 is not fixed relative to either the inner wall of the housing assembly 10 or the outer wall of the piezoelectric assembly 20, that is, both the outer side and the inner side of the limiting member 31 are the non-fixed sides, the equivalent friction coefficient of the limiting member 31 is a total friction coefficient existing between the limiting member 31 and the inner wall of the housing assembly 10 and between the limiting member 31 and the outer wall of the piezoelectric assembly 20.

In practical application, the limiting member 31 may be made of self-lubricated material (for example, polytetrafluoroethylene and polyether ether ketone) to reduce the friction between the limiting member 31 and the housing assembly 10 and/or between the limiting member 31 and the piezoelectric assembly 20, and to guide the piezoelectric assembly 20, such that extension and contraction of the piezoelectric assembly 20 is smooth and unobstructed, and phenomena of movement blocking and stack fracture are prevented. Moreover, the self-lubricated material also has certain elasticity, so as to buffer displacement and vibration of the piezoelectric assembly 20 in a radial direction, and prevent the piezoelectric assembly from being fractured after vibration or impact.

In practical application, cross sections of the accommodating chamber 11 and the piezoelectric assembly 20 are generally circular, and the limiting member 31 may be an annular workpiece made of self-lubricated material. Certainly, the limiting member 31 may also be a plurality of rectangular workpieces made of self-lubricated material, etc., which has no influence on the example.

In a first instance, an outer side of the limiting member 31 is closely attached to the inner wall of the housing assembly 10. An inner side of the limiting member is closely attached to the outer wall of the piezoelectric assembly 20. The lubricated surfaces are at least provided on the outer side and the inner side of the limiting member 31. In the instance, the limiting member 31 is arranged between the inner wall of the housing assembly 10 and the outer wall of the piezoelectric assembly 20 in an interference fit manner. Both the inner side and the outer side of the limiting member 31 are the non-fixed sides. By setting an inner surface and an outer surface as the lubricated surfaces, friction forces between the piezoelectric assembly 20 and the limiting member 31 and between the limiting member 31 and the housing assembly 10 during movement may be reduced to prevent the limiting member 31 from generating large stress due to large friction forces in movement of the piezoelectric assembly 20, and further prevent the piezoelectric assembly 20 from being fractured, and the limiting member 31 may guide the movement of the piezoelectric assembly 20.

In a second instance, an outer side of the limiting member 31 is fixedly connected to the inner wall of the housing assembly 10, an inner side of the limiting member is closely attached to the outer wall of the piezoelectric assembly 20, and the lubricated surface is at least arranged on the inner side of the limiting member 31. In the instance, the outer side of the limiting member 31 is the fixed side, and the inner side is the non-fixed side. By setting an inner surface as the lubricated surface, the friction force between the piezoelectric assembly 20 and the limiting member 31 during movement may be reduced to prevent the limiting member 31 from generating large stress due to large friction forces in movement of the piezoelectric assembly 20, and further prevent the piezoelectric assembly 20 from being fractured, and the limiting member 31 may guide the movement of the piezoelectric assembly 20.

In a third instance, an outer side of the limiting member 31 is closely attached to the inner wall of the housing assembly 10, an inner side of the limiting member is fixedly connected to the outer wall of the piezoelectric assembly 20, and the lubricated surface is at least arranged on the outer side of the limiting member 31. In the instance, the inner side of the limiting member 31 is the fixed side, and the outer side is the non-fixed side. By setting an outer surface as the lubricated surface, the friction between the limiting member 31 and the housing assembly 10 during movement may be reduced to prevent the limiting member 31 from generating large stress due to large friction forces in movement of the piezoelectric assembly 20, and further prevent the piezoelectric assembly 20 from being fractured, and the limiting member 31 may guide the movement of the piezoelectric assembly 20.

As shown in Fig. 6, in a fourth instance, when the limiting member 31 is arranged at a joint of two adjacent piezoelectric elements 21, the protective assembly 30 further includes an adapter 32. The adapter 32 is fixedly connected between the two adjacent piezoelectric elements 21. An inner side of the limiting member 31 is fixedly connected to the adapter 32, and an outer side of the limiting member is closely attached to the inner wall of the housing assembly 10. The lubricated surface is at least arranged on the outer side of the limiting member 31. In the instance, the inner side of the limiting member 31 is the fixed side, and the outer side is the non-fixed side. By setting an outer surface as the lubricated surface, the friction between the limiting member 31 and the housing assembly 10 during movement may be reduced to prevent the limiting member 31 from generating large stress due to large friction forces in movement of the piezoelectric assembly 20, and further prevent the piezoelectric assembly 20 from being fractured, and the limiting member 31 may guide the movement of the piezoelectric assembly 20.

It should be noted that compared with the fourth instance, the protective assembly 30 according to the first instance to the third instance has characteristics of a simple structure, low cost and suitability for piezoelectric actuators with a low load force and a medium displacement stroke since it only includes the limiting member 31. The protective assembly 30 in the fourth instance includes the limiting member 31 and the adapter 32. It is precisely because of the design of the adapter 32 that the protective assembly 30 shown in the fourth instance is suitable for piezoelectric actuators with a higher displacement stroke.

For the above instance, when the outer side of the limiting member 31 is the non-fixed side, a position of the inner wall of the housing assembly 10 opposite the limiting member 31 is provided with a sliding groove 12. The limiting member 31 is arranged in the sliding groove 12, such that the movement of the limiting member 31 is limited.

As shown in Fig. 7, the cover plate 40 is arranged at the opening of the accommodating chamber 11 and is connected with the housing assembly 10. The cover plate 40 has a through opening 41 with a stepped cross section. In practical application, the cover plate 40 may be manufactured together with the housing assembly 10, or even formed integrally together with the housing assembly.

The output assembly 50 includes a base 51 and a penetration member 52. The base 51 is connected with the piezoelectric assembly 20. The penetration member 52 is arranged on the base 51 and extends upwards to pass through the through opening 41. The output assembly 50 has a stepped cross section, and the output assembly 50 and the cover plate 40 define a movement space at a wide area of the through opening 41.

In some embodiments, the output assembly 50 is a rigid structural member directly and fixedly connected with the piezoelectric assembly 20 for outputting a position of the piezoelectric assembly 20 directly to an outer end of the piezoelectric actuator.

In some embodiments, a first gap $\delta 1$ and a second gap $\delta 2$ are formed between an outer wall of the penetration member 52 and an inner wall of the through opening 41, and the second gap $\delta 2$ is greater than the first gap $\delta 1$; and the first gap $\delta 1$ satisfies a formula $\delta 1 < \omega_{max}$, where $\omega_{max}$ is a maximum deflection of flexible deformation of the piezoelectric assembly.

As shown in Fig. 7, the elastic assembly 60 is arranged in the movement space and arranged around an outer side of the penetration member 52. In some embodiments, the elastic assembly 60 is located between the cover plate 40 and the base 51. An elastic force generated after compression deformation of the elastic assembly 60 reacts on the piezoelectric assembly 20 to apply a pre-tightening force to the piezoelectric assembly 20, so as to accelerate retraction of the piezoelectric assembly 20. In practical application, the elastic assembly 60 includes a disc spring and/or a spring.

As described in the foregoing (Background Art), according to causes of fracture of a long stack, the fracture may be classified into three types: (1) eccentric fracture under stress, (2) compression strut buckling fracture, and (3) vibration fracture. Hereinafter, performance of the piezoelectric actuator of the example is briefly analyzed based on the three fracture cases. The protective assembly 30 of the piezoelectric actuator of the example has the structure shown in the fourth instance.

(1) Eccentric fracture under stress

For the piezoelectric actuator structure of the example, an eccentric working condition under stress is actually a coupling state of an axial force and a tangential force. The two stress cases are separated for analysis.

For the case of a tangential force, the piezoelectric assembly 20 may be simplified as a cantilever beam structure with one end fixed, as shown in Fig. 8. $F_T$

is a tangential force applied to the cantilever beam structure. Deflection curve deformation of the cantilever beam

$$\omega_{max} = \frac{F_T L^3}{3EI}$$

satisfies a formula , $\omega_{max}$ is a maximum deflection of flexible deformation of the piezoelectric assembly, $F_T$ is the tangential force, L is the length of the piezoelectric assembly, E is a Young's modulus of the piezoelectric assembly, I is a section moment of inertia of the piezoelectric assembly, and EI is a flexural stiffness of a section of the piezoelectric assembly.

It can be seen that when the length of the piezoelectric assembly 20 in the axial direction increases, the overall stiffness $\left( \frac{EI}{L^3} \right)$ of the piezoelectric assembly decreases. When there is a tangential force, the flexible deformation of the piezoelectric assembly 20 increases, and the piezoelectric assembly 20 is more prone to fracture failure accordingly. Thus, the first gap between the cover plate 40 and the output assembly 50 satisfies $\delta 1 < \omega_{max}$, such that the cover plate 40 supports the output assembly 50 and the piezoelectric assembly 20, so as to prevent the piezoelectric assembly 20 from continuing to deform under an action of the tangential force, and prevent the piezoelectric assembly from fracture. That is to say, as long as a gap value satisfies $\delta 1 < \omega_{max}$, the piezoelectric assembly 20 is able to be guaranteed not to fracture under the action of the tangential force.

For a case of an axial force, as mentioned above, when the first gap between the cover plate 40 and the output assembly 50 is controlled within a small range, the piezoelectric assembly 20 may be simplified into an slender strut structure with two fixed ends, as shown in Fig. 9. An Euler's formula for a critical pressure

$$P_{cr} = \frac{\pi^2 EI}{(\mu' L)^2}$$

of the compression strut is , where $P_{cr}$ is the critical pressure of the compression strut, E is the Young's modulus of the piezoelectric assembly, I is the section moment of inertia of the piezoelectric assembly, EI is the flexural stiffness of a section of the piezoelectric assembly, $\mu'$ is a length coefficient, L is the length of the piezoelectric assembly. In this case, $\mu' = 0.5$, such that the critical pressure of the compression strut becomes

$$P_{cr} = \frac{4\pi^2 EI}{L^2} .$$

It can be seen that when the length of the piezoelectric assembly 20 increases, the critical pressure of the compression strut is greatly reduced, and the compression strut is more likely to be fractured in a compressed state. For the piezoelectric assembly of given material and section, only by increasing positioning points and decomposing the slender strut into a combination of a plurality of short struts, the critical pressure of the compression strut is abel to be increased, and the compressive fracture is able to be prevented.

In other words, the piezoelectric assembly 20 is divided into a plurality of thick and short compression struts by using the adapter 32. In this case, the piezoelectric assembly 20 may be equivalent to a plurality of slender struts with two fixed ends. For example, the piezoelectric assembly 20 is divided into (n + 1) slender struts by using n adapters 32, and the critical pressure of the compression struts satisfies the formula

$$P_{cr} = \frac{(n + 1)4\pi^2 EI}{L^2}$$

. Obviously, the critical pressure of the compression struts of the piezoelectric assembly 20 is increased by (n + 1) times, which greatly reduces possibility of a middle fracture of the piezoelectric assembly 20.

(2) Compression strut buckling fracture

The compression strut buckling fracture is similar to the axial force fracture above, which is not repeated herein.

(3) Vibration fracture

As mentioned above, when the first gap $\delta 1$ between the cover plate 40 and the output assembly 50 is controlled within a small range, the piezoelectric assembly 20 may be simplified into a vibration system model of a simply supported beam, as shown in Fig. 10. Characteristics of free vibration of the piezoelectric assembly are analyzed through a static deformation method and satisfy the formula

$$\begin{cases} mg = k_{eq}\delta_{st} \\ \omega_0 = \sqrt{\dfrac{k_{eq}}{m}} \end{cases}$$

, where m is an equivalent mass of the vibration system, g is an acceleration of gravity, $k_{eq}$ is an equivalent stiffness of a vibration system, $\delta_{st}$ is a static deformation under an effect of an equivalent mass concentration, and $\omega_0$ is a natural frequency of the vibration system. In the simply supported beam vibration system, gravity is concentrated at a midpoint of the beam, such that

$$\delta_{st} = \frac{L^3}{48EI} mg$$

, where L is the length of the piezoelectric assembly, E is the Young's modulus of the piezoelectric assembly, I is the section moment of inertia of the piezoelectric assembly, EI is the flexural stiffness of a section of the piezoelectric assembly, such

$$\omega_0 = \sqrt{\frac{48EI}{mL^3}}$$

that the natural frequency .

It can be seen that for the piezoelectric assembly with given material and section, the slender strut may also be decomposed into a combination of a plurality of short struts by increasing positioning points, such that the natural frequency of the overall system is improved, and the piezoelectric actuator is prevented from resonance-induced fracture due to external impact or vibration.

In other words, the piezoelectric assembly 20 is divided into a plurality of thick and short compression struts by using the adapters 32. For example, the piezoelectric assembly 20 is divided into (n + 1) compression struts by using n adapters 32. In this case, the natural frequency of the piezoelectric assembly 20 becomes

$$\omega_0 = \sqrt{\frac{48EI}{m\left(\dfrac{L}{n+1}\right)^3}}$$

. Obviously, the natural frequency of the piezoelectric assembly 20 is also greatly improved, and low-frequency vibration and impact do not cause large-amplitude vibration of the piezoelectric assembly 20, such that a risk of vibration fracture is greatly reduced.

Correspondingly, the examples further provide a moving device. The moving device includes the piezoelectric actuator above. The moving device may be any existing device applied to a piezoelectric actuator, which is not limited herein.

In summary, in the piezoelectric actuator and the moving device of the present invention, one or more limit positions are added to the piezoelectric assembly in the radial direction by adding the protective assembly, so as to reduce the flexible deformation of the piezoelectric assembly and prevent the piezoelectric assembly from fracturing. Moreover, the protective assembly is also able to serve as a guide and provide a certain axial movement space, such that extension and contraction of the piezoelectric assembly is smooth and unobstructed, and phenomena of movement halt and stack fracture are prevented. Furthermore, the protective assembly is beneficial to increase a length of the piezoelectric assembly, so as to increase a stroke of the piezoelectric actuator. The piezoelectric actuator disclosed in the present invention not only has high stability and high reliability, but also has a longer stroke. Thus, the present invention effectively overcomes various defects in the prior art and has high industrial utilization value.

The above examples are merely illustrative of principles and effects of the present invention, and are not intended to limit the present invention. Modifications and variations of the above examples may be made by those skilled in the art without departing from the spirit and scope of the present invention. Therefore, all equivalent modifications or changes made by those with ordinary knowledge in the technical field without departing from the spirit and technical ideas disclosed in the present invention should still be covered by the claims of the present invention.

**Claims**

1. A piezoelectric actuator, comprising:

a housing assembly (10) internally provided with an accommodating chamber (11) having an opening at an end;
a piezoelectric assembly (20) arranged in the accommodating chamber (11), an end fixed at a bottom of the accommodating chamber (11) away from the opening, and comprising a plurality of piezoelectric elements (21), wherein the piezoelectric elements (21) are stacked sequentially in an axial direction; and
at least one protective assembly (30) arranged in the accommodating chamber (11), wherein at least a part of the protective assembly (30) is arranged between an inner wall of the housing assembly (10) and an outer wall of the piezoelectric assembly (20); wherein when two or more protective assemblies (30) are arranged, a plurality of protective assemblies (30) are spaced one above another;
the protective assembly (30) comprises a limiting member (31), at most one side of the limiting member (31) is fixed relative to the inner wall of the housing assembly (10) or the outer wall of the piezoelectric assembly (20), and a non-fixed side of the limiting member (31) is attached to the inner wall of the housing assembly (10) and/or the outer wall of the piezoelectric assembly (20); the limiting member (31) has at least one lubricated surface, and the lubricated surface is at least arranged on the non-fixed side of the limiting member (31); and
an equivalent friction coefficient of the limiting member (31) satisfies a formula

$$\begin{cases} k(D - \delta)\mu \leq \sigma A \\ k = \dfrac{EA_i}{D} \\ \sigma = Max(\sigma_{ad}, \sigma_{ce}) \end{cases}$$

, wherein k is a stiffness of the limiting member (31), D is a thickness of the limiting member (31), $\delta$ is a distance between the inner wall of the housing assembly (10) and the outer wall of the piezoelectric assembly (20), $\mu$ is the equivalent friction coefficient of the limiting member (31), E is a Young's modulus of the limiting member (31), A is a cross sectional area of the piezoelectric assembly (20), Ai is an effective pressing area of the piezoelectric assembly (20) to the limiting member (31), $\sigma$ is a tensile strength of the piezoelectric assembly (20), $\sigma_{ad}$ **is a** tensile adhesion strength of the piezoelectric assembly (20), and $\sigma_{ce}$ is a tensile strength of a single piece of piezoelectric ceramic of the piezoelectric assembly (20).

2. The piezoelectric actuator according to claim 1, wherein an outer side of the limiting member (31) is fixedly connected to the inner wall of the housing assembly (10), an inner side of the limiting member (31) is closely attached to the outer wall of the piezoelectric assembly (20), and the lubricated surface is at least arranged on the inner side of the limiting member (31).

3. The piezoelectric actuator according to claim 1, wherein an outer side of the limiting member (31) is closely attached to the inner wall of the housing assembly (10), an inner side of the limiting member (31) is fixedly connected to the outer wall of the piezoelectric assembly (20), and the lubricated surface is at least arranged on the outer side of the limiting member (31).

4. The piezoelectric actuator according to claim 1, wherein an outer side of the limiting member (31) is closely attached to the inner wall of the housing assembly (10), an inner side of the limiting member (31) is closely attached to the outer wall of the piezoelectric assembly (20), and the lubricated surfaces are at least provided on the outer side and the inner side of the limiting member (31).

5. The piezoelectric actuator according to claim 1, wherein when the limiting member (31) is arranged at a joint of two adjacent piezoelectric elements (21), the protective assembly (30) further comprises an adapter (32), the adapter (32) is fixedly connected between the two adjacent piezoelectric elements (21), an inner side of the limiting member (31) is fixedly connected to the adapter (32), an outer side of the limiting member (31) is closely attached to the inner wall of the housing assembly (10), and in this case, the lubricated surface is at least arranged on the outer side of the limiting member (31).

6. The piezoelectric actuator according to any one of claims 3-5, wherein a sliding groove (12) is formed on the inner wall of the housing assembly (10) opposite the limiting member (31), and the limiting member (31) is arranged in the sliding groove (12).

7. The piezoelectric actuator according to claim 1, wherein the piezoelectric actuator further comprises:

a cover plate (40) arranged at the opening, wherein the cover plate (40) is connected with the housing assembly (10), and the cover plate (40) has a through opening (41) with a stepped cross section; and
an output assembly (50) comprising a base (51) and a penetration member (52), wherein the base (51) is connected with the piezoelectric assembly (20), the penetration member (52) is arranged on the base (51) and extends upwards to pass through the through opening (41), the output assembly (50) has a stepped cross section, and the output assembly (50) and the cover plate (40) define a movement space at a wide area of the through opening (41).

8. The piezoelectric actuator according to claim 7, wherein the piezoelectric actuator further comprises: an elastic assembly (60) arranged in the movement space, wherein the elastic assembly (60) is arranged around an outer side of the penetration member (52).

9. The piezoelectric actuator according to claim 8, wherein the elastic assembly (60) comprises a disc spring and/or a spring.

10. The piezoelectric actuator according to claim 7, wherein a first gap and a second gap are formed between an outer wall of the penetration member (52) and an inner wall of the through opening (41), and the second gap is greater than the first gap; and the first gap satisfies a formula $\delta 1 < \omega_{max}$, wherein $\delta 1$ is the first gap, and $\omega_{max}$ is a maximum deflection of flexible deformation of the piezoelectric assembly (20).

11. The piezoelectric actuator according to claim 1, wherein the piezoelectric element (21) comprises a single piece of piezoelectric ceramic or a piezoelectric ceramic stack, and the piezoelectric ceramic stack comprises at least two single piece of piezoelectric ceramics stacked one above the other.

12. A moving device, comprising the piezoelectric actuator according to any one of claims 1-11.

Fig. 1

Fig. 2

Fig. 3

Fig. 4

Fig. 5

Fig. 6

Fig. 7

Fig. 8

Fig. 9

Fig. 10

| | **INTERNATIONAL SEARCH REPORT** | International application No. |
|---|---|---|
| | | **PCT/CN2023/101163** |

**A.     CLASSIFICATION OF SUBJECT MATTER**

H10N30/88(2023.01)i;  H10N30/20(2023.01)i

According to International Patent Classification (IPC) or to both national classification and IPC

**B.     FIELDS SEARCHED**

Minimum documentation searched (classification system followed by classification symbols)

IPC: H01L

Documentation searched other than minimum documentation to the extent that such documents are included in the fields searched

Electronic data base consulted during the international search (name of data base and, where practicable, search terms used)

CNTXT, ENTXT, ENTXTC, DWPI, CNKI: 压电致动器, 腔室, 空腔, 保护组件, 限位, 润滑, 堆叠, 断裂, electrostrictive, piezoelectric, actuator, cavity, chamber, protect, limit, lubricate, stack, crack

**C.     DOCUMENTS CONSIDERED TO BE RELEVANT**

| Category* | Citation of document, with indication, where appropriate, of the relevant passages | Relevant to claim No. |
|---|---|---|
| PX | CN 114784178 A (SHANGHAI YINGUAN SEMICONDUCTOR TECHNOLOGY CO., LTD.) 22 July 2022 (2022-07-22)<br>  description, paragraphs [0033]-[0066], and figures 1-10 | 1-12 |
| A | CN 113315412 A (SHANGHAI YINGUAN SEMICONDUCTOR TECHNOLOGY CO., LTD.) 27 August 2021 (2021-08-27)<br>  entire document | 1-12 |
| A | US 5986386 A (DAIMLER CHRYSLER AG) 16 November 1999 (1999-11-16)<br>  entire document | 1-12 |
| A | WO 2009027360 A2 (ROBERT BOSCH GMBH) 05 March 2009 (2009-03-05)<br>  entire document | 1-12 |

☐ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **13 September 2023** | **14 September 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2023/101163**

| Patent document cited in search report | | | Publication date (day/month/year) | Patent family member(s) | | | Publication date (day/month/year) |
|---|---|---|---|---|---|---|---|
| CN | 114784178 | A | 22 July 2022 | CN | 114784178 | B | 09 September 2022 |
| CN | 113315412 | A | 27 August 2021 | CN | 113315412 | B | 06 December 2022 |
| US | 5986386 | A | 16 November 1999 | JPH | 11136965 | A | 21 May 1999 |
| | | | | EP | 0901171 | A1 | 10 March 1999 |
| | | | | DE | 19738407 | A1 | 11 March 1999 |
| | | | | DE | 19738407 | C2 | 04 November 1999 |
| WO | 2009027360 | A2 | 05 March 2009 | DE | 102007040508 | A1 | 05 March 2009 |
| | | | | WO | 2009027360 | A3 | 07 May 2009 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210708090